Europäisches Patentamt

European Patent Office

Office européen des brevets

(11) Numéro de publication : **0 323 925 B1**

# FASCICULE DE BREVET EUROPEEN

(45) Date de publication du fascicule du brevet :
**10.06.92 Bulletin 92/24**

(51) Int. Cl.$^5$ : **G11C 27/04, G11C 19/28**

(21) Numéro de dépôt : **89400009.0**

(22) Date de dépôt : **03.01.89**

(54) **Duplicateur de charges pour dispositif à transfert de charges.**

(30) Priorité : **05.01.88 FR 8800028**

(43) Date de publication de la demande :
**12.07.89 Bulletin 89/28**

(45) Mention de la délivrance du brevet :
**10.06.92 Bulletin 92/24**

(84) Etats contractants désignés :
**DE FR GB NL**

(56) Documents cités :
**PROCEEDINGS OF THE 5TH INTERNATIONAL
CONFERENCE ON CHARGE-COUPLED DEVI-
CES, septembre 1979, éditeur J. MAVOR,
pages 156-160;C. CARRISON et al.:
"Performance characteristics of a CCD analog memory/signal processor"**

(56) Documents cités :
**PATENT ABSTRACTS OF JAPAN, vol. 5, no. 46
(P-64)[718], 27 mars 1981; & JP-A-5 689 (NIP-
PON DENKI K.K.) 06-01-1981
IEEE JOURNAL OF SOLID-STATE CIRCUITS,
vol. SC-11, no. 1, février 1976, pages 197-202,
IEEE, New York, US; K.R. HENSE et al.:"Linear
charge-coupled device signal-processing
techniques"**

(73) Titulaire : **THOMSON-CSF
51, Esplanade du Général de Gaulle
F-92800 Puteaux (FR)**

(72) Inventeur : **Berger, Jean-Luc
THOMSON-CSF SCPI 19, avenue de Messine
F-75008 Paris (FR)**
Inventeur : **Arques, Marc
THOMSON-CSF SCPI 19, avenue de Messine
F-75008 Paris (FR)**

(74) Mandataire : **Guérin, Michel et al
THOMSON-CSF SCPI
F-92045 PARIS LA DEFENSE CEDEX 67 (FR)**

## Description

L'invention concerne les dispositifs à transfert de charges. Elle s'applique spécialement mais non exclusivement aux dispositifs de lecture des charges engendrées dans des matrices photosensibles, notamment lorsque ces charges doivent être transférées directement d'une colonne de sortie de la matrice vers un registre à décalage à transfert de charges.

On s'est aperçu dans certains cas qu'il pouvait être utile de disposer d'un circuit de duplication de charges capable d'engendrer et de stocker, dans une zone de stockage auxiliaire, une charge électrique qui est la réplique exacte, à l'échelle un ou avec un coefficient multiplicateur fixe, plus petit ou plus grand que un, d'une autre charge.

Pour donner un exemple d'une telle utilité, on peut indiquer par exemple le cas suivant: on veut transférer dans un registre à décalage à transfert de charges un paquet de charges issu d'une colonne de sortie d'une matrice photosensible; mais on veut au préalable effectuer un traitement de signal consistant à transférer N fois successivement de la colonne vers une zone de stockage intermédiaire le paquet de charges considéré, et stocker à un endroit la somme des charges transférées au cours de ces N opérations; pour faire le transfert N fois de suite, il faut après chaque transfert réinjecter sur la colonne la charge transférée; pour pouvoir à la fois accumuler la charge transférée avec les charges issus des autres transferts, et réinjecter sur la colonne cette charge, on a été conduit à réaliser un duplicateur de charges qui permet à la fois de réinjecter la charge initiale et de la recopier pour transférer la copie là où sont accumulées les charges qu'on veut additionner.

A titre indicatif, ce traitement de signal a été conçu pour réduire le bruit de transfert de charges de la colonne vers le registre à transfert de charges. En effet, le bruit engendré au cours d'un transfert est aléatoire; si on fait N transferts de la même charge et que le bruit engendré au cours d'un transfert n'est pas corrélé avec les bruits des autres transferts, on constate et l'on vérifie par le calcul que le bruit moyen affectant la charge globale transférée (c'est-à-dire la somme ou la moyenne des charges transférées) est réduit dans un rapport $N^{1/2}$ proportionnellement au bruit affectant un transfert unique.

C'est donc pourquoi on a cherché à réaliser un duplicateur de charges: la charge à lire sur la colonne de sortie de la matrice est transférée N fois de la colonne vers une zone de stockage intermédiaire, et N fois en sens inverse pour revenir sur la colonne, et avant chaque retour elle est dupliquée; on fait la moyenne des charges dupliquées, et c'est cette moyenne qui est affectée d'un bruit de transfert réduit et qui peut être introduite comme signal de sortie dans le registre à décalage.

Le lecteur intéressé pourra se référer à la demande de brevet EP-A-0 323 924 déposée ce même jour par le même déposant que la présente demande et mentionnant le même inventeur.

Un duplicateur de charges selon le préambule de la revendication 1 est connu du document: "Performance characteristics of a CCD analog memory/signal processor" par C. Carrison et al., Proceedings of the 5th international conference on charge-coupled devices, septembre 1979, pages 156-160.

Un but de la présente invention est de réaliser un duplicateur de charges qui introduise un bruit aussi faible que possible de manière à pouvoir engendrer et stocker dans une région de stockage une charge proportionnelle, avec un coefficient multiplicatif parfaitement fixe, à une charge de référence.

Le duplicateur de charges selon l'invention comprend
- une première grille de stockage au dessus d'une première région de stockage dans laquelle peut être stockée la charge de référence;
- une deuxième grille de stockage au dessus d'une deuxième région de stockage dans laquelle est engendrée une charge réplique proportionnelle à la charge de référence;
- un premier injecteur de charges comportant une première grille de passage pour introduire la charge de référence à dupliquer sous la première grille de stockage;
- un deuxième injecteur de charges comportant une deuxième grille de passage à proximité de la deuxième grille de stockage; caractérisé en ce qu'il comporte
- un comparateur ayant une première entrée reliée à la première grille de stockage, une deuxième entrée reliée à la deuxième grille de stockage, et une sortie reliée à la deuxième grille de passage;
- un moyen pour appliquer dans un premier temps une tension de référence sur les deux entrées du comparateur, et pour, dans un deuxième temps, laisser flottantes ces entrées et les grilles qui leur sont reliées.

Le comparateur a une caractéristique entrée/sortie avec un front de transition aussi raide que possible entre un état de sortie bas et un état de sortie haut. De préférence, la transition entre l'état bas et l'état haut s'effectue pour une tension d'entrée différentielle très proche de zéro.

Le deuxième injecteur de charges comprend de préférence une diode susceptible d'être portée à un potentiel suffisant pour permettre l'injection de charges sous la deuxième grille de stockage lorsque la sortie du comparateur fournit un niveau opposé à celui qu'elle fournit pour une tension différentielle nulle à l'entrée.

Le premier injecteur de charges peut comprendre une diode d'entrée et un amplificateur à gain négatif dont l'entrée est reliée à la diode d'entrée et la sortie à la première grille de passage (interposée entre la diode d'entrée et la première grille de stockage).

Enfin, on peut prévoir de préférence une première grille de blocage intercalée entre la première grille de passage et la première grille de stockage, et de même une deuxième grille de blocage intercalée entre la deuxième grille de passage et la deuxième grille de stockage.

D'autres caractéristiques et avantages de l'invention apparaîtront à la lecture de la description détaillée qui suit et qui est faite en référence aux dessins annexés dans lesquels:

– la figure 1 représente schématiquement une structure de duplicateur de charges selon l'invention,

– la figure 2 représente la caractéristique de tension de sortie en fonction de la tension différentielle d'entrée du comparateur utilisé dans le duplicateur;

– la figure 3 représente les profils de potentiel dans la structure de la figure 1, au cours des différentes phases de fonctionnement du duplicateur.

Dans l'exemple décrit, on a supposé que la charge à dupliquer provient d'un conducteur de colonne Cj d'une matrice photosensible.

On prévoit alors un injecteur de charges pour transférer la charge Qs, provenant de la colonne Cj, vers une zone de stockage de charges située sous une première grille de stockage G1.

L'injecteur de charges comprend au moins une diode d'injection D1 reliée au conducteur de colonne Cj, et une grille de passage GP1, adjacente à la diode D1, interposée entre la diode et la grille de stockage G1.

Si la charge à dupliquer était déjà stockée sous une grille, l'injecteur serait réduit à sa plus simple expression: il ne comporterait que la grille de passage GP1 entre cette grille et la grille de stockage G1.

Dans l'exemple préférentiel décrit, l'injecteur de charges comprend en outre un amplificateur AMP1, à gain négatif, dont l'entrée est reliée au conducteur de colonne Cj et dont la sortie commande la grille de passage GP1. Cet amplificateur est utile lorsqu'on veut réduire le bruit d'injection de la charge Qs lors de son transfert de la colonne Cj vers la zone de stockage sous la grille G1.

De préférence, on prévoit encore une grille de blocage entre la grille de passage GP1 et la grille de stockage G1. Cette grille peut être portée à un potentiel haut lorsqu'on veut mieux découpler l'influence mutuelle des potentiels des grilles GP1 et G1, et à un potentiel bas lorsqu'on veut isoler complètement la région de stockage sous G1 de la diode D1.

Le duplicateur de charges comprend en outre une deuxième grille de stockage de charges G2 au dessus d'une deuxième région de stockage de charges; c'est dans cette deuxième région qu'on va engendrer et stocker la charge réplique, proportionnelle à la charge de référence Qs.

Un deuxième injecteur de charges permet d'engendrer et déverser des charges sous la grille G2. Cet injecteur comporte une diode D2 dont le potentiel peut être porté, pendant la phase de duplication à une valeur permettant effectivement une injection et un déversement de charges sous la grille.

L'injecteur de charges comprend aussi une grille de passage GP2, interposée entre la diode et la grille de stockage G2; enfin, il peut comprendre une grille de blocage P2, similaire à la grille de blocage P1 et permettant de diminuer l'influence mutuelle des potentiels des grilles GP2 et G2.

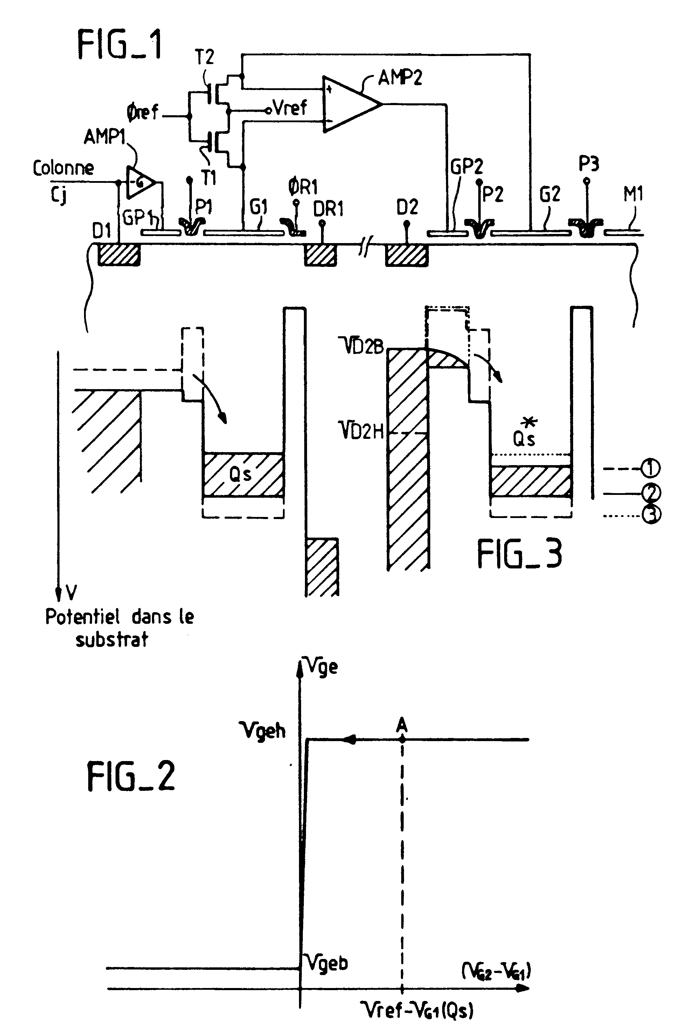

Un comparateur AMP2 possède une première entrée reliée à la grille de stockage G1, une deuxième entrée reliée à la grille de stockage G2, et une sortie reliée à la grille de passage GP2 du deuxième injecteur de charges. Ce comparateur a une caractéristique de tension de sortie Vge en fonction de la tension différentielle d'entrée Vg2-Vg1 qui peut être celle de la figure 2 dans le cas où le dispositif à transfert de charges est réalisé dans un substrat semiconducteur de type essentiellement P et où les tensions de commande des grilles sont positives pour permettre les transferts de charge et négatives pour les interdire.

Dans tous les cas, le comparateur est monté de telle manière que lorsque le potentiel de la grille G1 varie par suite d'une arrivée de charges sous la grille G1, alors la sortie du comparateur bascule très rapidement dans un état opposé à celui qu'elle a lorsque la tension différentielle d'entrée est nulle.

Dans l'exemple décrit, la sortie du comparateur fournit une tension à un niveau bas Vgeb si la tension différentielle d'entrée est négative ou nulle, et un niveau haut Vgeh dès que cette tension devient positive, c'est-à-dire dès que le potentiel de la grille G1 devient inférieur à celui de la grille G2.

Les entrées du comparateur sont par ailleurs connectées chacune à la source d'un transistor MOS respectif, T1 pour pour l'entrée reliée à la grille G1 et T2 pour l'entrée reliée à la grille G2; ces transistors jouent le rôle d'interrupteurs; ils ont leurs drains reliés à un potentiel de référence Vref et leurs grilles connectées à une borne de commande qui permet de bloquer les deux transistors ou de les rendre conducteurs. Le potentiel Vref est suffisamment élevé pour constituer le fond d'un puits de potentiel dans lequel pourra s'accumuler la charge Qs à dupliquer.

Enfin, sur la figure 1, on peut voir une grille de passage P3, adjacente à la grille G2 et permettant, lorsque l'opération de duplication est terminée, de transférer la charge dupliquée de la zone où elle est stockée vers une autre zone où on en a besoin, par exemple sous une grille M1. D'autre part, on a représenté sur la figure 1 une grille supplémentaire interposée entre une zone d'évacuation de charges DR1 et la grille G1. Cette grille permet aussi d'évacuer vers la zone DR1 la charge de référence stockée sous la grille G1 lorsqu'on n'a plus besoin de cette charge.

La duplication de la charge Qs se fait de la manière suivante, illustrée par les niveaux de potentiels représentés respectivement en traits tiretés (au départ), en traits pleins (pendant un phase d'injection de la charge Qs sous la grille G1), et en traits pointillés (pendant la duplication).

### 1. Départ (traits tiretés)

La grille P1 est à un niveau bas empêchant toute injection de charges de la diode D1 vers la grille de stockage G1; le potentiel Vref est appliqué sur les deux entrées du comparateur AMP2; le niveau de sortie de celui-ci est donc bas (Vgeb) et la grille de passage GP2 bloque toute possibilité d'injection de charges de la diode D2 (deuxième injecteur) vers la grille de stockage G2.

### 2. Transfert de la charge de référence (en traits pleins)

Les transistors T1 et T2 sont alors bloqués et les grilles G1 et G2 deviennent flottantes; dans le même temps, la grille P1 est portée à un potentiel haut, ce qui permet l'injection de la quantité de charges Qs sous la grille G1; par symétrie, on applique de préférence simultanément le même niveau de potentiel sur la grille de blocage P2; le potentiel de la grille G1 diminue au fur et à mesure que des charges s'accumulent sous cette grille; très rapidement après le début de l'injection, le comparateur AMP2 bascule car le potentiel de la grille G2 est toujours à Vref pendant que celui de la grille G1 diminue; la sortie du comparateur passe au niveau Vgeh; le potentiel de la grille de passage GP2 du deuxième injecteur devient suffisamment élevé pour autoriser le passage de charges de la diode D2 vers la grille de stockage G2.

### 3. Génération de la charge dupliquée Qs* (en traits pointillés)

La diode D2 est alors portée (si elle ne l'était pas déjà) à un potentiel suffisamment bas pour permettre l'injection de charges de la diode D2 vers la grille de stockage G2 à travers la grille de passage GP2 et la grille de blocage P2. Au fur et à mesure de cette injection, le potentiel de la grille G2 s'abaisse; lorsque le potentiel de la grille G2 atteint celui de la grille G1 (qui lui aussi s'est abaissé proportionnellement à la quantité de charges Qs reçue de la colonne Cj), le comparateur AMP2 rebascule et bloque la grille de passage GP2, interdisant toute injection supplémentaire de charges à partir de la diode D2.

La charge QS* alors présente sous la grille G2 est la même que la charge Qs présente sous la grille G1, si du moins les grilles G1 et G2 sont identiques, c'est-à-dire si une même quantité de charges induit un même potentiel sous l'une ou l'autre; cela implique en principe que les grilles aient la même surface, la même épaisseur d'isolant entre elles et le substrat semiconducteur dans lequel s'accumulent les charges, le même dopage de ce substrat, etc.

Mais on peut aussi envisager que la charge dupliquée Qs* ne soit pas égale mais proportionnelle à la charge de référence Qs; dans ce cas, on prévoira justement une dissymétrie entre la construction de la grille G2 et celle de la grille G1; si la surface de la grille G2 est dans un rapport k avec la surface de la grille G1, tous les autres paramètres de structure étant identiques, la charge dupliquée Qs* sera aussi dans un rapport k avec la charge de référence Qs.

On peut remarquer que la charge Qs* est bien la réplique exacte de la charge Qs stockée sous la grille G1, c'est-à-dire qu'il y a un très faible bruit supplémentaire engendré par cette duplication (par exemple par rapport au bruit engendré lors du transfert de colonne à la grille G1 par l'intermédiaire de la diode D1) à condition que la capacité de la diode D2 soit trés inférieure à celle de l'ensemble de la diode D1 et de la colonne Cj.

L'erreur sur la valeur de la charge dupliquée ne provient que de la tension de décalage du comparateur, c'est-à-dire la tension pour laquelle le comparateur bascule dans un sens ou dans l'autre.

### Revendications

1. Duplicateur de charges pour dispositif à transfert de charges, pour engendrer et stocker dans une deuxième région de stockage une charge réplique (Qs*) proportionnelle à une charge de référence (Qs) engendrée et stockée dans une première région de stockage, comprenant

– une première grille de stockage (G1) au dessus de la première région de stockage;

– une deuxième grille de stockage (G2) au dessus de la deuxième région de stockage;

– un premier injecteur de charges comprenant une première grille de passage (GP1) pour introduire sous la première grille de stockage la charge de référence à dupliquer;

– un deuxième injecteur de charges comportant une deuxième grille de passage (GP2) à proximité de la deuxième grille de stockage (G2), caractérisé en ce qu'il comporte

– un comparateur (AMP2) ayant une première entrée reliée à la première grille de stockage et une deuxième entrée reliée à la deuxième grille de stockage, et une sortie reliée à la deuxième grille de passage (GP2);

– un moyen pour appliquer dans un premier temps une tension de référence (Vref) sur les deux entrées du comparateur et pour dans un deuxième temps laisser flottantes ces entrées et les grilles qui leur sont reliées.

2. Duplicateur de charges selon la revendication 1, caractérisé en ce que le comparateur fournit sur sa sortie un niveau haut (Vgeh) ou un niveau bas (Vgeb) selon la valeur de la tension différentielle entre ses entrées, avec une transition très raide entre les deux niveaux pour une tension différentielle aussi proche que possible de zéro.

3. Duplicateur de charges selon la revendication 2, caractérisé en ce que le niveau de tension sur la sortie du comparateur lorsque la tension différentielle d'entrée est nulle correspond à une tension de blocage de la deuxième grille de passage (GP2), interdisant toute injection de charges sous la deuxième grille de stockage.

4. Duplicateur de charges selon l'une des revendications 1 à 3, caractérisé en ce que le premier injecteur de charges comprend une diode d'entrée (D1) et un amplificateur à gain négatif (AMP1) dont l'entrée est reliée à la diode d'entrée et la sortie à la première grille de passage , cette dernière étant interposée entre la diode d'entrée et la première grille de stockage.

5. Duplicateur de charges selon l'une des revendications 1 à 4, caractérisé en ce que le deuxième injecteur de charges comprend une diode (D2) à proximité de la deuxième grille de passage (GP2) et un moyen pour porter cette diode à un potentiel bas ($V_{D2B}$) pour autoriser une injection de charges.

6. Duplicateur de charges selon la revendication 5, caractérisé en ce que la diode (D2) du deuxième injecteur a une capacité faible devant celle de l'ensemble du premier injecteur et du conducteur d'entrée (Cj).

7. Duplicateur selon l'une des revendications 1 à 6, caractérisé en ce que, entre l'une et/ou l'autre de chacune des grilles de passage des injecteurs et la grille de stockage correspondante, est prévue une grille de blocage (P1, P2) commandée par un signal de blocage avant l'application de la tension de référence aux entrées du comparateur.

**Patentansprüche**

1. Ladungsverdopplungseinrichtung für Ladungsverschiebungseinrichtung, um in einem zweiten Speicherbereich eine Ladungskopie (Qs*) zu erzeugen und zu speichern, die proportional zu einer Bezugsladung (Qs) ist, die in einem ersten Speicherbereich erzeugt wird und gespeichert ist, mit
– einem ersten Speichergate (G1) oberhalb des ersten Speicherbereichs;
– einem zweiten Speichergate (G2) oberhalb des zweiten Speicherbereichs;
– einem ersten Ladungsinjektor, der ein erstes Durchlaßgate (GP1) aufweist, um unter das erste Speichergate die zu verdoppelnde Bezugsladung einzuleiten;
– einem zweiten Ladungsinjektor, der in der Nähe des zweiten Speichergates (G2) ein zweites Durchlaßgate (GP2) aufweist, dadurch gekennzeichnet, daß sie umfaßt:
  – einen Komparator (AMP2), der einen mit dem ersten Speichergate verbundenen ersten Eingang, einen mit dem zweiten Speichergate verbundenen zweiten Eingang und einen mit dem zweiten Durchlaßgate (GP2) verbundenen Ausgang besitzt;
  – ein Mittel, um während eines ersten Zeitraums an die zwei Eingänge des Komparators eine Bezugsspannung (Vref) anzulegen und um während eines zweiten Zeitraums diese Eingänge und die mit ihnen verbundenen Gates in der Schwebe zu halten.

2. Ladungsverdopplungseinrichtung gemäß Anspruch 1, dadurch gekennzeichnet, daß der Komparator an seinem Ausgang je nach dem Wert der Spannungsdifferenz zwischen seinen Eingängen einen hohen Pegel (Vgeh) oder niedrigen Pegel (Vgeb) liefert und für eine so nahe wie möglich bei Null liegende Spannungsdifferenz einen sehr steilen Übergang zwischen den beiden Pegeln aufweist.

3. Ladungsverdopplungseinrichtung gemäß Anspruch 2, dadurch gekennzeichnet, daß der Spannungspegel am Ausgang des Komparators in dem Fall, daß die Spannungsdifferenz Null ist, einer Sperrspannung für das zweite Durchlaßgate (GP2) entspricht, die jede Ladungsinjektion unter das zweite Speichergate verhindert.

4. Ladungsverdopplungseinrichtung gemäß einem der Ansprüche 1 bis 3, dadurch gekennzeichnet, daß der erste Ladungsinjektor eine Eingangsdiode (D1) und einen Verstärker (AMP1) mit negativer Verstärkung aufweist, dessen Eingang mit der Eingangsdiode und dessen Ausgang mit dem ersten Durchlaßgate verbunden ist, wobei dieses letztere zwischen die Eingangsdiode und das erste Speichergate eingefügt ist.

5. Ladungsverdopplungseinrichtung gemäß einem der Ansprüche 1 bis 4, dadurch gekennzeichnet, daß der zweite Ladungsinjektor eine in der Nähe des zweiten Durchlaßgates (GP2) sich befindende Diode (D2) und ein Mittel zum Halten dieser Diode auf niedrigem Potential ($V_{D2B}$) aufweist, um eine Ladungsinjektion zuzulassen.

6. Ladungsverdopplungseinrichtung gemäß Anspruch 5, dadurch gekennzeichnet, daß die Diode (D2) des zweiten Injektors eine Kapazität besitzt, die etwas über der Gesamtkapazität des ersten Injektors und des Eingangsleiters (Cj) liegt.

7. Ladungsverdopplungseinrichtung gemäß einem der Ansprüche 1 bis 6, dadurch gekennzeichnet, daß zwischen dem einen und/oder dem anderen der beiden Durchlaßgates der Injektoren und dem entsprechenden Speichergate ein Sperrgate (P1, P2) vorgesehen ist, das vor dem Anlegen der Bezugsspannung an die Eingänge des Komparators von einem Sperrsignal gesteuert wird.

## Claims

1. A charge duplicating means for a charge transfer device in order to produce and store, in a second storing region, a duplicate charge (Qs*) proportional to a reference charge (Qs) produced and stored in a first storing region comprising:
   – a first storing gate (G1) above the first storing region;
   – a second storing gate (G2) above the second storing region;
   – a first charge injector comprising a first passage gate (GP1) for the introduction the reference charge, which is to be duplicated, under the first storing gate;
   – a second charge injector comprising a second passage gate (GP2) in the vicinity of the second storing gate (G2), characterized in that it comprises:
      – a comparator (AMP2) having a first input connected with the first storing gate and a second input connected with the second storing gate, and an output connected with the second passage gate (GP2);
      – a means for the application at a first time of a reference voltage (Vref) to the two inputs of the comparator and at a second time to allow these inputs, and the gates with which they are connected, to float.

2. The charge duplicating means as claimed in claim 1, characterized in that the comparator provides at its output a high level (Vgeh) or a low level (Vgeb) in accordance with the value of the differential voltage between its inputs, with a very steep transition between the levels for a differential voltage which is as close as possible to zero.

3. The charge duplicating means as claimed in claim 2, characterized in that when the input differential voltage is zero, the level of the voltage at the output of the comparator corresponds to a blocking voltage for the second passage gate (GP2), thus forbidding any injection of charges under the second storing gate.

4. The charge duplicating means as claimed in any one of claims 1 through 3, characterized in that the first charge injector comprises an input diode (D1) and a negative gain amplifier (AMP1) of which the input is connected with the input diode and the output with the first passage gate, the latter being placed between the input diode and the first storing gate.

5. The charge duplicating means as claimed in any one of the preceding claims 1 through 4, characterized in that the second charge injector comprises a diode (D2) in the vicinity of the second passage gate (GP2) and a means for placing this diode at a low potential ($V_{D2B}$) in order to authorize injection of charges.

6. The charge duplicating means as claimed in claim 5, characterized in that the diode (D2) of the second injector has a low capacity in relation to that of the arrangement comprising the first injector and the input conductor (Cj).

7. The charge duplicating means as claimed in any one of claims 1 through 6, characterized in that between the one and/or the other of the passage gates of the injectors and the corresponding storing gate a blocking gate (P1, P2) is provided controlled by a blocking signal prior to the application of the reference voltage to the inputs of the comparator.

FIG_1

T2

AMP2

Øref — Vref

AMP1

Colonne
Cj

T1

GP2
P2
P3
G2
M1

GP1
P1
G1
ØR1
DR1
D2

D1

VD2B

VD2H — Qs*

Qs

Qs

① ② ③

FIG_3

V

Potentiel dans le
substrat

Vge

Vgeh

A

FIG_2

Vgeb

$(V_{G2}-V_{G1})$

$V_{ref}-V_{G1}(Q_s)$